# EUROPÄISCHE PATENTSCHRIFT

(11) **EP 4 352 479 B1**
(45) Veröffentlichungstag und Bekanntmachung des Hinweises auf die Patenterteilung: **27.05.2026**
(21) Anmeldenummer: 22737723.1
(22) Anmeldetag: 03.06.2022
(51) Int. Cl.: G01L 25/00, G01D 21/00, G01M 5/00, G01D 18/00, G01R 31/28

(54) **VERFAHREN ZUR INSTALLATION UND ZUM BETREIBEN EINER MESSANORDNUNG MIT RÄUMLICH WEIT VERTEILTEN SENSOR-MESSSTELLEN**
METHOD FOR INSTALLING AND OPERATING A MEASURING ASSEMBLY WITH SPATIALLY WIDELY DISTRIBUTED SENSOR MEASURING POINTS
PROCÉDÉ D'INSTALLATION ET DE FONCTIONNEMENT D'UN ENSEMBLE DE MESURE À POINTS DE MESURE DE CAPTEURS À LARGE RÉPARTITION SPATIALE

(30) Priorität: 11.06.2021 DE 102021003016
(43) Veröffentlichungstag der Anmeldung: 17.04.2024
(73) Patentinhaber: Hottinger Brüel & Kjaer GmbH, 64293 Darmstadt (DE)
(72) Erfinder: SCHÄCK, Marco M., 63322 Rödemark (DE); DÖRFEL, Michael, 64347 Griesheim (DE); DI NATALE, Sandro, 68309 Mannheim (DE); TCHERNIAK, Dmitri, Humlebaek, 3050 (DK); SIRONI, Gianmarco, 64625 Bensheim (DE)
(74) Vertreter: Müller, Thomas
(86) Internationale Anmeldenummer: PCT/DE2022/000060
(87) Internationale Veröffentlichungsnummer: WO 2022/258092

(56) Entgegenhaltungen:
- EP-B1- 2 048 478
- KR-A- 20050 051 577
- KR-A- 20210 044 276
- US-A1- 2014 026 671

## Beschreibung

Die Erfindung betrifft ein Verfahren zur Installation und zum Betreiben einer Messanordnung mit einer Vielzahl von Sensor-Messstellen, die räumlich weit verteilt sind. Unter der Formulierung "räumlich weit verteilt" ist Folgendes zu verstehen: Um z.B. Kräfte oder Temperaturen oder andere Messgrößen an großen Objekten zu messen, müssen an diesen Objekten an vielen Stellen Sensoren befestigt werden. Solche Objekte sind z. B. Bauwerke, Brücken, Kräne oder auch Flugzeuge. Besonders kompliziert ist die Messung an Brücken, die mehrere Kilometer lang sind, denn dort sind mitunter auch mehrere Tausend Sensoren zu befestigen. Jeder Sensor ist mit einem elektrischen Kabel verbunden. Die Kabel werden zu Kabelbündeln zusammengefasst und bis zu den Messverstärkern geführt. Die Messverstärker befinden sich an einem zentralen Ort.

Ein typischer Anwendungsfall ist das Messen von Kräften und Dehnungen mittels sogenannter Dehnungsmesstreifen oder das Messen der Temperatur mittels eines Thermoelements.

Um Kräfte an Brückenkonstruktionen zu messen, werden die Kraftsensoren - vorzugsweise sogenannte Dehnungsmessstreifen - an den Stellen befestigt, an denen die Dehnung gemessen werden soll. Gleiches gilt für Temperatursensoren, wenn Temperaturen bzw. Temperaturdifferenzen gemessen werden sollen.

Nachfolgend wird nur noch von Sensoren gesprochen und damit sind Sensoren für verschiedene Messgrößen gemeint, vorzugsweise jedoch Dehnungsmessstreifen.

Aus dem Stand der Technik sind unterschiedlichste Messverfahren und Messvorrichtungen bekannt, die jedoch z.T. fehleranfällig und daher weniger geeignet sind, Messanordnungen mit räumlich weit verteilten Sensor-Messstellen zu betreiben.

So ist in dem Dokument US 2014/026671 A1 ein System zum Messen der Belastung einer Brücke beim Befahren durch ein Fahrzeug beschrieben, wobei durch wenigstens ein Messmodul mit mehreren Messkanal-Einheiten vorzugsweise DMS-Sensoren zugeordnet sind. Diese Sensoren sind zum Anbringen an einer Brücke vorgesehen, wobei die Sensoren Messsignale, bevorzugt drahtgebunden, an die ihnen jeweils zugeordneten Messkanal-Einheiten übermitteln. Weiterhin ist noch eine Übertragungs-Schnittstelle vorgesehen, um die Messdaten zu einer entfernten Auswerteeinheit zu übertragen.

Das Dokument EP 2 048 478 B1 beschreibt Verfahren zur Erkennung eines Sensors an einem Messverstärker und ein Verfahren zur Synchronisation eines Sensors mit einem Messverstärker. Der Sensor ist mittels eines Steckers mit einem Messverstärker verbindbar. Der Messverstärker umfasst wenigstens ein Kontaktpaar mit einem ersten Kontakt und einem zweiten Kontakt. Der Stecker umfasst wenigstens ein Kontaktpaar mit einem ersten Kontakt und einem mit dem ersten Kontakt gekoppelten zweiten Kontakt, wobei die Kontakte des Messverstärkers und des Steckers miteinander kontaktierbar sind. Zum Erkennen, ob der Sensor an dem Messverstärker angeschlossen ist, legt der Messverstärker ein elektrisches Potential an einen Kontakt des Kontaktpaares an und misst das elektrische Potential an dem zweiten Kontakt des Kontaktpaares, wobei der Messverstärker das elektrische Potential des ersten Kontakts mit dem elektrischen Potential des zweiten Kontakts vergleicht. Stellt der Messverstärker hierbei aufgrund des gleichen Potentials an den Kontakten fest, dass ein Sensor angeschlossen ist, kann der Messverstärker die Daten aus einem Speicher des Sensors auslesen und der Messverstärker wird aufgrund der ausgelesenen Daten justiert.

Das Dokument KR 2005 0051577 A beschreibt ein Messsystem für eine Baustruktur unter Verwendung einer drahtlosen Übertragungstechnologie, um Messkosten zu senken. Eine Sensorschnittstelle ist mit einem wenigstens einem Sensor verbunden. Ein Sendercontroller weist einen AD-Wandler auf. Der AD-Wandler digitalisiert ein analoges Signal, um es drahtlos zu übertragen. Ein Sender überträgt das digitale Signal. Ein Empfänger empfängt das vom Sender übertragene digitale Signal. Ein Empfängercontroller steuert den Empfänger, demoduliert das Signal und führt eine Datenkonvertierung durch. Diese Daten werden in einem Datenspeicher, wie z.B. einem Computer speichert und analysiert.

Das Dokument KR 2021 0044276 A beschreibt ein Verfahren zur Messung mindestens einer physikalischen Messgröße; unter Verwendung von Verfahrensparametern eines Messsystems, welche Verfahrensparameter mehrere für die Messung der physikalischen Messgröße benötigte Messeinheiten umfassen, welche Verfahrensparameter die Verfahrensschritte von mindestens einer Erfassung der physikalischen Messgröße als Messsignal, von mindestens einer Auswertung vom Messsignal zu einem Messwert, von mindestens einer Darstellung vom Messsignal oder Messwert und von mindestens einer Weiterverarbeitung vom Messsignal oder Messwert umfassen; und mit einem Computerprogrammprodukt zur Einstellung und Überwachung der Verfahrensparameter; wobei jeder Verfahrensparameter in einem ihm zugeordneten Fenster auf einer graphischen Benutzeroberfläche wiedergegeben wird; wobei jedes Fenster einklappbar ist, ein eingeklapptes Fenster verwendet genau den Raum auf der graphischen Benutzeroberfläche, um den zugeordneten Verfahrensparameter in Kurzform wiederzugeben; und wobei jedes Fenster aufklappbar ist, ein aufgeklapptes Fenster verwendet genau den Raum auf der graphischen Benutzeroberfläche, um den zugeordneten Verfahrensparameter in Langform wiederzugeben. Durch gezieltes Ein- und Aufklappen von den Verfahrensparametern zugeordneten Fenstern auf der graphischen Benutzeroberfläche wird Raum gewonnen, um Informationen übersichtlich und verständlich wiederzugeben. So sind alle Verfahrensparameter in ihnen zugeordneten Fenstern wiedergegeben, bei eingeklappten Fenstern werden die Verfahrensparameter in Kurzform wiedergegeben, bei ausgeklappten Fenstern werden die Verfahrensparameter in Langform wiedergegeben. Je nach dem gewünschten Informationsgehalt kann ein Benutzer Fenster ein- und aufklappen.

Vorstehend beschriebener Stand der Technik ist jedoch nicht für nachstehend beschriebene Messaufgabe geeignet.

Spezifisch für die vorliegende Messaufgabe ist die Anforderung, dass jede Messstelle an einen separaten Messkanal eines Messgeräts angeschlossen werden muss. Wenn z. B. eine Eisenbahnbrücke mehrere tausend Messstellen aufweist, ist der Gesamtaufwand für die Installation sehr hoch.

Nach der Installation aller Sensoren muss jeder Sensor bzw. das dazugehörige Messkabel dem richtigen Messkanal des Messverstärkers zugeordnet werden. Mit anderen Worten, eine aussagefähige Messung ist nur möglich, wenn bekannt ist, welcher Messkanal zu welcher Messstelle gehört.

Die Zuordnung eines Messkanals zu einer bestimmtem Messstelle ist trivial, wenn es sich um nur wenige Messstellen und kurze Messkabel handelt. Der Messtechniker kann in einem solchen Fall den Verlauf des Messkabels von der Messstelle bis zum Eingang des Messverstärkerkanals visuell verfolgen. Wenn allerdings die Messkabel an einer Eisenbahnbrücke mehrere hundert Kilometer lang sind, müssen mittels aufwändiger elektrischer Durchgangsprüfungen oder Markierungen die jeweils zugehörigen Kabelenden ermittelt werden. Schon hierbei können Verwechslungen entstehen, d.h. ein Messkabel kann versehentlich an einen falschen Messkanal angeschlossen werden.

Um dieses Problem zu lösen, wird in dem Dokument JP 2004-294 382 A eine Lösung mit Identifizierungs-Tags vorgeschlagen, die jedoch aufwändig und kostenintensiv ist.

Solche Messungen werden in der Regel nur einmalig oder in großen Zeitabständen durchgeführt. Nach jeder Messung werden die Sensoren meist wieder entfernt. Daher besteht auch ein hohes Interesse daran, den Aufwand für die Installation der Messanordnung zu senken. Die mögliche Verwechslung der Messkabel beim Anschließen an die Messverstärkerkanäle ist jedoch nur eine erste Fehlerquelle.

Es gibt jedoch noch eine zweite Fehlerquelle:
Jeder Sensor, vorzugsweise aus der Gruppe der Dehnungsmessstreifen oder der Temperatur-Sensoren, hat bestimmte elektrische Eigenschaften, die sich von Sensor zu Sensor unterscheiden. Diese Eigenschaften werden Parameter genannt. Diese Parameter sind bekannt und müssen am Messverstärker eingestellt werden, um ein optimales Messergebnis zu erzielen. Wenn z. B. ein Dehnungsmessstreifen-Sensor 4 Parameter aufweist, müssen diese 4 Parameter von Hand an dem Messverstärker eingestellt werden. Die Einstellung der Parameter erfolgt über Drehknöpfe oder über Tasten am Messverstärker. Nur ein einziger falsch eingegebener Parameter führt zu einem falschen Messergebnis. Hier besteht also bereits bei wenigen Messstellen bzw. wenigen Sensoren eine erhöhte Fehlergefahr, je größer die Anzahl der Parameter ist.

Bei z.B. 500 Messstellen und 4 Parametern müsste demnach der Messtechniker 2000 Parametereinstellungen manuell vornehmen. Es liegt somit auf der Hand, dass es auch bei höchster gedanklicher Konzentration der Messtechniker, welche die Parametrierung vornehmen, zu Fehleinstellungen kommen kann, die das Messergebnis unverwertbar machen. Bei 5000 Messstellen sind 20.000 Parametereinstellungen erforderlich. Bei so vielen Messstellen sind Fehleinstellungen nahezu unvermeidlich.

Dieses Problem ist in der Messtechnik schon seit Jahrzehnten bekannt und wird bisher auf verschiedene Weise gelöst. Es gibt drei prinzipielle Lösungen:

### Lösung a.

Die Sensoren weisen Speicherchips auf, in denen die individuellen Sensor-Parameter abgespeichert worden sind. Diese sogenannten Transducer Electronic Data Sheets (TEDS) enthalten alle erforderlichen Parameter-Daten. Der Messverstärker ist so ausgebildet, dass er diese Parameter-Daten auslesen kann und sich danach selbst auf die optimale Messgenauigkeit einstellt. Dieser Vorgang des individuellen Anpassens des Messverstärkerkanals an einen Sensor wird Parametrierung genannt. Die TEDS sind entweder im Sensorkabel oder im Sensor-Stecker oder auf dem Sensorträger integriert, wie das Dokument US 7856888 B2 zeigt. TEDS basieren auf dem IEEE 1451.4-Standard, der weltweit angewendet wird. Der Vorteil eines mit einem TEDS bestückten Sensors besteht also darin, dass der Sensor mit seinen individuellen Eigenschaften von einem Messverstärker automatisch erkannt werden kann. Dadurch entfällt die manuelle Eingabe der verschiedenen Sensorparameter am Messverstärker.

### Lösung b.

Bei der Herstellung der Sensoren wird versucht, die Fertigungstechnologie so zu perfektionieren, dass alle Sensoren näherungsweise die gleichen Parameter aufweisen. Das ist bei einigen Sensortypen möglich, bei anderen Sensortypen nicht. Meistens ist es dann nicht möglich, wenn besonders hohe Anforderungen an die Messgenauigkeit gestellt werden, wie z. B. bei der Kraftmessung mit Dehnungsmessstreifen.

### Lösung c.

Die Sensoren werden nach ihrer Herstellung durch verschiedene Prüfschritte klassifiziert und in Gruppen unterteilt, so dass in jeder Gruppe Sensoren mit annähernd gleichen Parametern liegen. Diese Lösung ist jedoch für Sensoren mit mehr als zwei Parametern selten geeignet.

Bei den Lösungen b und c ist es demnach nicht erforderlich, die Sensorparameter am Messverstärkerkanal individuell einzugeben.

Besonders für genaue Messungen und wenn der Sensor mehrere Parameter aufweist, hat sich der Einsatz von TEDS durchgesetzt.

Allerdings gibt es auch sehr spezielle und sehr seltene Messaufgaben, für die noch keine praktikablen Lösungen existieren.

Dehnungsmessstreifen z. B. sind kostengünstige Massenartikel, die aus den folgenden Gründen nicht mit einem TEDS gekoppelt werden: Die Herstellungskosten eines TEDS können höher werden als die Herstellungskosten des Dehnungsmessstreifens, denn das Speichern der individuellen Sensorparameter auf dem TEDS ist ebenfalls mit erheblichem Aufwand verbunden. Gleiches gilt für bestimmte Thermoelemente oder andere Sensoren, die ebenfalls ohne TEDS verwendet werden.

Die Gruppe der Dehnungsmessstreifen bildet eine gewisse Ausnahme bei den Massensensoren. Dehnungsmessstreifen werden fast immer zur Durchführung genauer Messungen eingesetzt. Das erfordert aber das Einstellen der individuellen Parameter jedes Dehnungsmessstreifens von Hand am Messverstärkerkanal. Es gibt aber keine Fertigungstechnologie, mit der Dehnungsmessstreifen mit TEDS in Großserien-Produktion gefertigt werden können, denn bei den meisten Dehnungsmessungen sind TEDS nicht erforderlich.

Zum besseren Verständnis der Problematik wird nachfolgend konkret beschrieben, wie ein Dehnungsmessstreifen installiert und parametriert wird.

Der Dehnungsmessstreifen ist eine dünne Kunststofffolie mit meanderförmigen Leiterbahnen und hat eine Kantenlänge von z. B. 10 mm. Der Dehnungsmessstreifen wird auf das Messobjekt geklebt, z.B. auf eine Blattfeder aus Stahl. Wenn die Blattfeder deformiert wird, verändert sich auch die Materialdehnung an der Oberfläche der Blattfeder. Diese Dehnung wird auf den Dehnungsmessstreifen übertragen, wodurch sich dessen ohmscher Widerstand ändert. Diese Widerstandsänderung ist proportional der Dehnung. Der ohmsche Widerstand wird mit dem Messverstärker gemessen, an den der Dehnungsmessstreifen über ein Messkabel elektrisch angeschlossen ist.

Die Parametrierung des Dehnungsmessstreifens wird am Beispiel eines von mehreren Parametern erläutert: Einer der wichtigsten Parameter eines
Dehnungsmessstreifens ist seine Dehnungsempfindlichkeit und wird Dehnungsfaktor genannt. Der Dehnungsfaktor ist das Verhältnis der Widerstandsänderung zur Längenänderung, die bei der Dehnung des Messobjekts auftritt. Wie bereits erläutert, ist es aus fertigungstechnischen Gründen nicht möglich, Dehnungsmessstreifen mit absolut gleichem Dehnungsfaktor herzustellen. Deshalb liefert der Hersteller zu jedem Dehnungsmessstreifen ein Datenblatt, das die vom Hersteller ermittelten Parameter enthält.

Dieses Datenblatt ist ein Blatt Papier. Bei einer Parametrierung liest der Messtechniker die Parameter von diesem Blatt ab und stellt sie manuell am Messverstärkerkanal ein. Da in vielen Fällen weniger als z.B. 10 Messstellen vorliegen, ist diese manuelle Eingabe der Parameter seit Jahrzehnten üblich. Außerdem ist es bei so einer geringen Anzahl von Messkabeln möglich, jedes Messkabel an den richtigen Verstärkerkanal anzuschließen, ohne dass eine Verwechslung eintritt.

Bei einer Messsituation mit sehr vielen und räumlich weit verteilten Sensor-Messstellen ergeben sich aber völlig neuartige Probleme, die bisher nicht zufriedenstellend gelöst werden konnten. Mit anderen Worten, dieses umständliche Verfahren wird bisher auch bei sehr vielen und räumlich weit verteilten Sensor-Messstellen angewendet. Oft sind die Messstellen so weit voneinander entfernt, dass zwei Messtechniker sich über Sprechfunk verständigen müssen. Der erste Messtechniker ist am Ort der Messstelle und hat das Datenblatt, auf dem die nummerierte Messstelle und die Parameter des betreffenden Dehnungsmessstreifens enthalten sind. Diese Informationen gibt der erste Messtechniker per Sprechfunk an den zweiten Messtechniker, der an dem z.B. 800 Meter entfernten Messverstärker die Parameter von Hand einstellt.

Wie bereits erwähnt, kann ein richtiges Gesamt-Messergebnis nur erreicht werden, wenn tatsächlich alle Kabel korrekt angeschlossen sind und alle Messkanäle fehlerfrei parametriert sind. Bereits ein einzelnes verwechseltes Kabel oder ein versehentlich falsch vom Datenblatt abgelesener Parameter oder ein falsch eingestellter Parameter kann zu einem unbrauchbaren Gesamt-Messergebnis führen.

Bei einer hohen Anzahl an Messstellen sind zwangsläufig viele Zahlen von den Datenblättern abzulesen, per Sprechfunk zu übermitteln und am Messverstärker einzustellen. Das führt zu einer exponentiell hohen Fehlerquote. Demzufolge steigt auch der Aufwand zur Vermeidung dieser Fehler exponentiell.

Da aus vorstehend erläuterten Gründen der Einsatz von TEDS nicht infrage kommt, muss bisher mit extremen Kontrollaufwand die Verwechslung von Kabeln und die Falscheingabe der Parameter vermieden werden.

Insofern besteht die Aufgabe der Erfindung darin eine Messtechnik bereitzustellen, mit der die Installation und das Betreiben einer Messanordnung mit räumlich weit verteilten Sensor-Messstellen absolut fehlerfrei und mit einem geringen wirtschaftlichen Aufwand durchführbar ist.

Diese Aufgabe wird mit einem Verfahren nach Patentanspruch 1 gelöst.

Das Verfahren zur Installation und zum Betreiben einer Messanordnung mit räumlich weit verteilten Sensor-Messstellen umfasst nachfolgende Verfahrensschritte:
a. Fachmännisches Befestigen der Sensoren an dem Messobjekt, sodass eine ordnungsgemäße Messung durchführbar ist,
b. Anschließen von Messkabeln an die elektrischen Kontaktstellen der Sensoren,
c. Anschließen je eines Messkabels an je einen Messverstärker-Kanal, wobei die Reihenfolge unbeachtet bleiben kann,
d. Überprüfen, ob alle Messkabel an je einen Messverstärker-Kanal angeschlossen sind und das Messgerät für jeden Messkanal ein vorbestimmtes Messsignal anzeigt, welches die prinzipielle Funktion der Messkette "Sensor-Messkanal-Messgerät" bestätigt,
e. Erfassen der Parametrierdaten von dem zum jeweiligen Sensor gehörenden Datenblatt mittels einer Erfassungsvorrichtung, wobei die Parametrierdaten als Datenpaket in der Erfassungsvorrichtung zwischengespeichert werden,
f. Einspeisen des Parametrierdaten-Pakets in das Messkabelende, an dem der Sensor angeschlossen ist, oder direkt in den Sensor, wobei die Einspeisung z. B. induktiv oder mechanisch erfolgen kann,
g. Wenn der Messverstärker, d. h. der jeweilige Messkanal, alle zur Identifizierung und Parametrierung erforderlichen Informationen empfangen hat, generiert der Messverstärker ein Bestätigungssignal. Das Bestätigungssignal wird zu dem Sensor zurückgesendet und dort von einer Empfangsvorrichtung empfangen. Die Empfangsvorrichtung bestätigt dem Messtechniker am Sensorort optisch oder akustisch oder auf eine andere Weise, wie z. B. durch Vibration die fehlerfreie Parametrierung des Sensors.
   Das Bestätigungssignal kann über das Messkabel zurück gesendet werden. Es ist aber auch möglich, das Bestätigungssignal über einen anderen Informationskanal zu senden. Das Bestätigungssignals wird nur gesendet, wenn die Parametrierung des Sensors erfolgreich abgeschlossen werden konnte.
h. Wiederholung der Schritte e, f und g, bis alle Messverstärkerkanäle parametriert sind.

Mit diesen Verfahrensschritten a bis h werden die gewünschten Ergebnisse erzielt:
Verwendung herkömmlicher, kostengünstiger Sensoren ohne TEDS und Vermeidung von Einstell- und Verwechslungsfehlern bei der Parametrierung, völlig unabhängig von der Anzahl von Messstellen, die beliebig groß sein kann.

Vorteilhafte oder spezielle Weiterbildungen der Erfindung sind in den Ansprüchen 2 bis 5 erfasst.

Die Erfindung wird nachfolgend anhand schematischer Zeichnungen näher beschrieben:
- Fig. 1: zeigt eine mit einer Vielzahl von DMS-Sensoren bestückte Brücke als Messobjekt.
- Fig. 2: zeigt einen Teil des Messverstärkers mit einer Vielzahl von Messkabeln.
- Fig. 3: zeigt eine vergrößerte Detailansicht einer Messstelle.

### Bezugszeichenliste

1 - Messobjekt
2 - Sensor
3 - Ausschnittsvergrößerung vom Messobjekt
4 - Kabelstränge
5 - Messverstärker
6 - Messkabel
7 - vergrößert abgebildete Messstelle
8 - Einspeisestelle
9 - Einspeisestelle der Parametriersignale

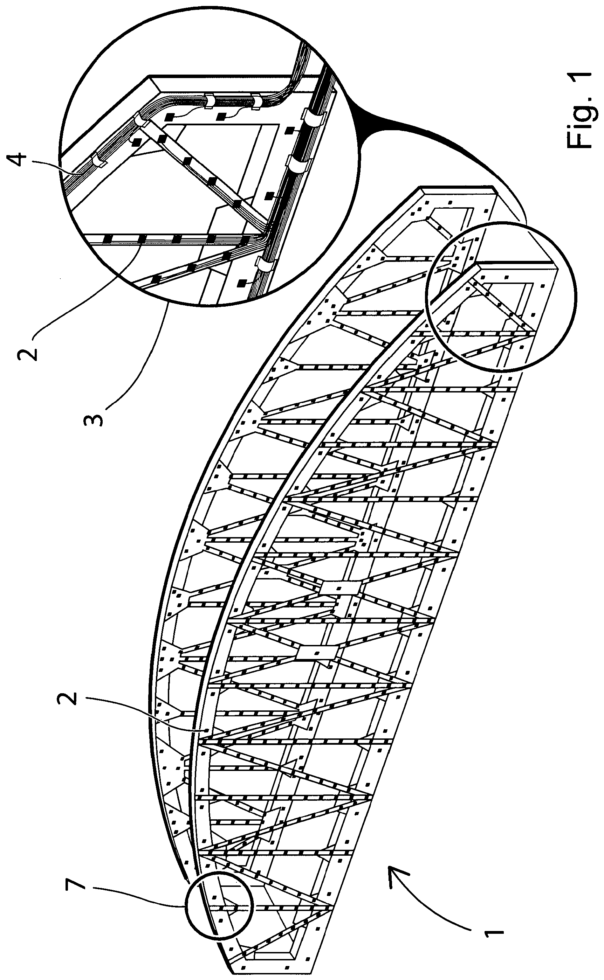

Die Fig. 1 zeigt eine mit einer Vielzahl von Dehnungsmessstreifen 2 bestückte Stahl-Brücke 1. Aus der vergrößerten Ansicht 3 geht hervor, dass jeder Dehnungsmessstreifen 2 über ein separates Kabel 6 an den Messverstärker 5 angeschlossen ist und die Kabel 6 zu Kabelsträngen 4 gebündelt sind. Auf Grund der Vielzahl der DMS-Sensoren 2 wird deutlich, dass der Installationsaufwand für die Messanordnung sehr hoch ist. Demzufolge sind Falsch-Messungen zu vermeiden.

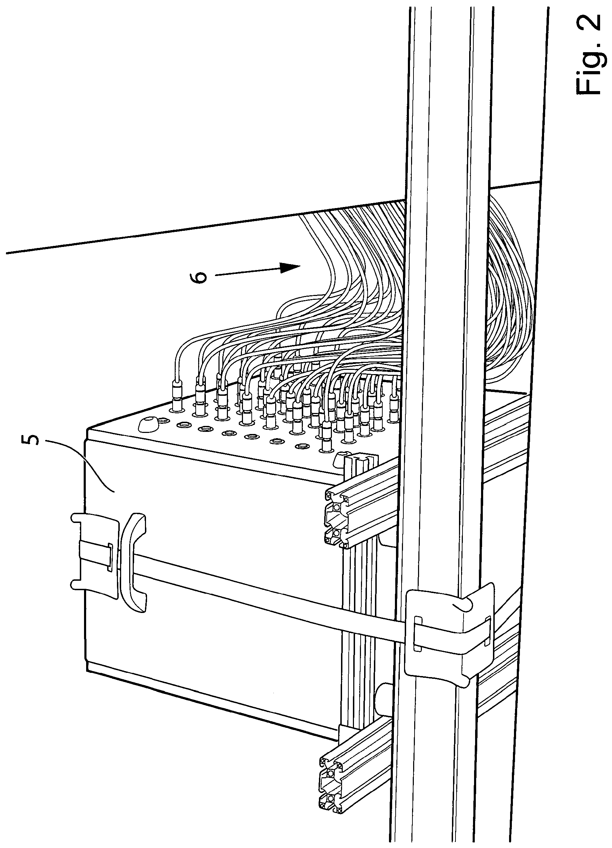

Fig. 2 zeigt einen Teil des Messverstärkers 5 mit einer Vielzahl von Messkabeln 6. Da die beiden Enden jedes Messkabels 6 weit entfernt voneinander sind, kann es augenscheinlich passieren, dass der Stecker eines Kabels 6 in eine falsche Buchse des Messverstärkers 5 gesteckt wird, ohne dass die Verwechslung der Messkabel 6 bemerkt wird. Dem Messtechniker ist klar, dass dadurch das Gesamt-Messergebnis unbrauchbar wird. Diese Gefahr wird durch die Erfindung beseitigt.

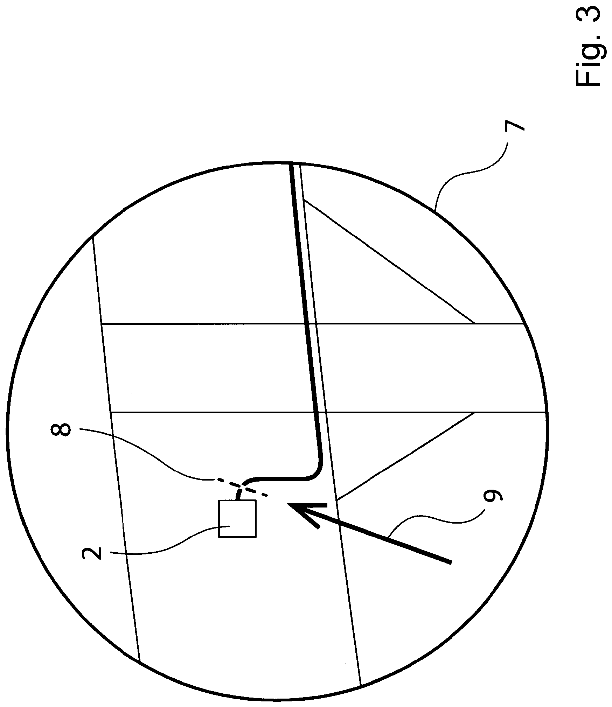

Fig. 3 zeigt die Ansicht 7 einer Messstelle mit einem Dehnungsmessstreifen-Sensor 2. Der Pfeil 9 deutet auf die Einspeisestelle 8, an der mittels einer Einspeisevorrichtung die Parametrierdaten zur Parametrierung eingespeist werden. Die Parametrierdaten werden dann an einen Messverstärkerkanal weitergeleitet. Die Einspeisevorrichtung kann z. B. eine induktiv wirkende Vorrichtung sein, mit der das Datenpaket mit den Parametrierdaten in die elektrische Anschlussleitung des Sensors eingespeist und an den Messverstärkerkanal gesendet wird.

Nachfolgend wird beschrieben, wie das Verfahren zur Installation und zum Betreiben einer Messanordnung mit räumlich weit verteilten Sensor-Messstellen durchgeführt wird:
a. Zuerst werden die Sensoren 2 an dem Messobjekt 1 messtechnisch vorschriftsmäßig angebracht. Damit ist gemeint, dass es für jeden Sensortyp eine vorgeschriebene Art der Befestigung gibt.
b. Anschließen von Messkabeln 6 an die befestigten Sensoren 2.
c. Anschließen je eines Messkabels 6 an je einen Messverstärker-Kanal, wobei die Reihenfolge unbeachtet bleiben kann. Dieser Schritt ist eine wesentliche Verbesserung dieses Verfahrens.
d. Überprüfen, ob alle Messkabel 6 an je einen Messverstärker-Kanal angeschlossen sind. Da die Anzahl der Sensoren 2 bekannt ist, ist automatisch auch die Anzahl der Messkabel 6 bekannt. Gleichzeitig wird überprüft, ob der Messverstärker für jeden Messkanal ein vorbestimmtes Messsignal anzeigt. Damit ist gemeint, dass ein Messtechniker weiß, welche durchschnittliche Größe ein Messsignal im Betriebszustand des Sensors auch ohne Parametrierung aufweist.
e. Scannen des Datenpakets mit den Parametrierdaten von dem zum jeweiligen Sensor gehörenden Papier-Datenblatt mittels einer Scanvorrichtung. Die Parametrierdaten können z.B. in einem QR-Code enthalten sein, der mit einem QR-Code-Leser abgelesen werden kann.
f. Wenn die gescannten Parametrierdaten in der Datenerfassungsvorrichtung zwischengespeichert sind, erfolgt das Einspeisen des zum jeweiligen Sensors 2 gehörenden Datenpakets mittels einer Einspeisevorrichtung in das Messkabel dieses Sensors 2. Die Einspeisung des Datenpakets kann z. B. induktiv oder optisch oder mechanisch erfolgen. Die Art der Einspeisung ist abhängig von der Sensortype. Üblicherweise erfolgt eine induktive Einspeisung, wenn es sich um Dehnungsmessstreifen oder Thermoelemente handelt. Auf Messstellen mit Dehnungsmessstreifen können aber auch mechanische Schwingungen aufgeprägt werden, in denen die Parametrierdaten einmoduliert sind. Das ist z. B. mit einem elektromagnetisch arbeitenden Vibrator möglich, dessen vibrierendes Element direkt auf den Dehnungsmesstreifen aufgesetzt wird.
g. Wenn der Messverstärker, d. h. der jeweilige Messkanal alle zur Identifizierung und Parametrierung erforderlichen Signale des jeweiligen Datenpakets empfangen hat, generiert der Messverstärker ein Bestätigungssignal, welches von einer Empfangsvorrichtung empfangen werden kann. Das Bestätigungssignal wird vorzugsweise über das Messkabel zurückgesendet und an der Einspeisestelle empfangen. Das Bestätigungssignals wird nur gesendet, wenn die Parametrierung des Sensors erfolgreich abgeschlossen sind. Es ist aber auch möglich, einen externen Übertragungskanal für die Übertragung des Bestätigungssignals zu nutzen. Das Bestätigungssignal kann vorzugsweise von der Einspeisevorrichtung ausgegeben werden, d.h. die Datenerfassungsvorrichtung, die Einspeisevorrichtung und die Empfangsvorrichtung für das Bestätigungssignal können in einem gemeinsamen Gehäuse angeordnet sein.
h. Wiederholung der Schritte e, f und g, bis alle Messverstärkerkanäle parametriert sind.

Das Datenpaket enthält wenigstens folgende Daten:
- Parametrierdaten des Sensors, die auf dem Papier-Datenblatt des jeweiligen Sensors z. B. als scannbarer QR-Code aufgedruckt sind und
- optional ortsbezogene Daten, die eine automatische Zuordnung des Sensors zur Lage bzw. Position am Messobjekt ermöglichen. Z.B. kann durch die zusätzliche Verwendung von GPS-Daten erkannt werden, wo sich der Sensor an einer Brücke befindet. Dazu ist es zweckmäßig, auch den GPS-Empfänger in das Gehäuse der Einspeisevorrichtung zu integrieren.

Mit diesem Verfahren wird die eingangs beschriebene Aufgabe der Erfindung gelöst.

## Patentansprüche

1. Verfahren zur Installation und zum Betreiben einer Messanordnung mit räumlich weit verteilten Sensor-Messstellen, wobei die Sensoren (2) keine Transducer Electronic Data Sheets (TEDS) enthalten und das Verfahren nachfolgende Schritte aufweist:
a. Befestigen der Sensoren (2) an dem Messobjekt (1),
b. Anschließen je eines Messkabels (6) an je einen Sensor (2),
c. Anschließen je eines Messkabels (6) an je einen Messverstärker-Kanal wenigstens eines Messverstärkers (5),
d. Überprüfen, ob jedes Messkabel (6) angeschlossen ist und das Messgerät an jedem Messkanal ein Messsignal anzeigt,
e. Erfassen der Parametrierdaten von dem zum jeweiligen Sensor (2) gehörenden Datenblatt mittels einer Erfassungsvorrichtung,
f. Einspeisen der Parametrierdaten in das Messkabelende, an dem der Sensor (2) angeschlossen ist, oder direkt in den Sensor (2),
g. Wenn der Messverstärker (5), d. h. der jeweilige Messkanal die zur Identifizierung und Parametrierung des betreffenden Sensors (2) erforderlichen Signale empfangen hat, generiert der Messverstärker (5) des jeweiligen Messkanals ein Bestätigungssignal und bestätigt einem Messtechniker am Sensorort die ordnungsgemäße Parametrierung des Sensors,
h. Wiederholung der Schritte e, f und g, bis alle Messverstärkerkanäle parametriert sind.

2. Verfahren nach Anspruch 1, wobei das Bestätigungssignal in Schritt g über das jeweilige Messkabel (6) gesendet wird.

3. Verfahren nach Anspruch 1, wobei das Bestätigungssignal in Schritt g nicht über das jeweilige Messkabel (6), sondern über einen anderen Informationskanal gesendet wird.

4. Verfahren nach Anspruch 1, wobei der Sensor (2) ein Dehnungsmessstreifen ist.

5. Verfahren nach Anspruch 1, wobei der Sensor (2) ein Thermoelement ist.

## Claims

1. A method for installing and operating a measurement assembly with sensor measurement points spatially distributed over a wide area, wherein the sensors (2) do not contain Transducer Electronic Data Sheets (TEDS) and the method comprises the following steps:
a. Mounting the sensors (2) on the measurement object (1),
b. Connecting one measurement cable (6) each to one sensor (2) each,
c. Connecting one measurement cable (6) each to one measurement amplifier channel each of at least one measurement amplifier (5),
d. Checking, whether each measurement cable (6) is connected, and that the measuring device displays a measurement signal on each measurement channel,
e. Capturing the parameterisation data from the data sheet belonging to the respective sensor (2) by means of a capture device,
f. Feeding the parameterisation data into the end of the measuring cable to which the sensor (2) is connected, or directly into the sensor (2),
g. Once the measurement amplifier (5), i.e. the respective measurement channel, has received the signals required for the identification and parameterisation of the relevant sensor (2), the measurement amplifier (5) of the respective measurement channel generates a confirmation signal and confirms to a measurement technician at the sensor location that the sensor has been correctly parameterised,
h. Repeating of steps e, f and g until all measurement amplifier channels have been parameterised.

2. Method according to claim 1, wherein the confirmation signal in step g is transmitted via the respective measurement cable (6).

3. Method according to claim 1, wherein the confirmation signal in step g is transmitted not via the respective measurement cable (6) but via another information channel.

4. Method according to claim 1, wherein the sensor (2) is a strain gauge.

5. Method according to claim 1, wherein the sensor (2) is a thermocouple.

## Revendications

1. Procédé d'installation et de fonctionnement d'un ensemble de mesure avec des points de mesure de capteur largement répartis dans l'espace, dans lequel les capteurs (2) ne contiennent pas de feuilles de données électroniques de transducteur (TEDS) et le procédé présente les étapes suivantes :
a. la fixation des capteurs (2) à l'objet de mesure (1),
b. le raccordement d'un câble de mesure (6) à chaque capteur (2),
c. le raccordement d'un câble de mesure (6) à chaque canal d'amplificateur de mesure au moins d'un amplificateur de mesure (5),
d. la vérification établissant si chaque câble de mesure (6) est raccordé et si l'appareil de mesure indique un signal de mesure au niveau de chaque canal de mesure,
e. la détection des données de paramétrage de la feuille de données appartenant au capteur (2) respectif au moyen d'un dispositif de détection,
f. l'introduction des données de paramétrage dans l'extrémité de câble de mesure, auquel le capteur (2) est raccordé, ou directement dans le capteur (2),
g. lorsque l'amplificateur de mesure (5), c'est-à-dire le canal de mesure respectif a reçu les signaux nécessaires à l'identification et au paramétrage du capteur (2) concerné, l'amplificateur de mesure (5) du canal de mesure respectif génère un signal de confirmation et confirme le paramétrage conforme du capteur à un technicien de mesure à l'emplacement du capteur,
h. la répétition des étapes e, f et g jusqu'à ce que tous les canaux d'amplificateur de mesure soient paramétrés.

2. Procédé selon la revendication 1, dans lequel le signal de confirmation est envoyé à l'étape g par le biais du câble de mesure (6) respectif.

3. Procédé selon la revendication 1, dans lequel le signal de confirmation n'est pas envoyé à l'étape g par le biais du câble de mesure (6) respectif mais par le biais d'un autre canal d'information.

4. Procédé selon la revendication 1, dans lequel le capteur (2) est une jauge de contrainte.

5. Procédé selon la revendication 1, dans lequel le capteur (2) est un élément thermique.
